# EUROPEAN PATENT APPLICATION

(11) **EP 4 759 493 A1**
(43) Date of publication of application: **17.06.2026**
(21) Application number: 23948557.6
(22) Date of filing: 01.12.2023
(51) Int. Cl.: B25J 15/06, F04B 37/16, F04B 39/00, F04B 41/00

(54) **VACUUM GENERATION DEVICE AND SUCTION DEVICE**

(30) Priority: 08.08.2023 US 202363531538 P
(71) Applicant: Minebea Mitsumi Inc., Kitasaku-gun, Nagano 3890293 (JP)
(72) Inventor: KITANO, Tomoaki, Kitasaku-gun, Nagano 389-0293 (JP); NISHIBU, Koki, Kitasaku-gun, Nagano 389-0293 (JP); SHIMOHATA, Takeshi, Kitasaku-gun, Nagano 389-0293 (JP); NAGASHIMA, Tatsuhiro, Kitasaku-gun, Nagano 389-0293 (JP); NISHIHASHI, Susumu, Kitasaku-gun, Nagano 389-0293 (JP)
(74) Representative: Winter, Brandl - Partnerschaft mbB
(86) International application number: PCT/JP2023/043193
(87) International publication number: WO 2025/032846

(57) **Abstract**

A vacuum generating device includes a main body (500), and a suction device (100) including a vacuum pump (160). The suction device (100) is removable from the main body. The main body (500) and the suction device (100) are engaged with each other by engagement mechanisms (134, 135, 514, and 515). The suction device (100) includes terminals (181 to 185) for supplying power to the vacuum pump (160) and a pipe (167) passing air sucked by operation of the vacuum pump (160). The main body (500) includes a connector (518) and the connection port (517). The terminals (181 to 185) are connected to the connector (518). The pipe (167) is connected to the connection port (517). The terminals (181 to 185) of the suction device (100) and the connector (518) of the main body (500), and the pipe (167) of the suction device (100) and the connection port (517) of the main body (500) are connected to each other on the same surface as a surface (S1) for engagement between the engagement mechanisms (134, 135, 514, and 515).

## Description

### Technical Field

The present invention relates to a vacuum generating device and an adsorption device.

### Background Art

There is a known vacuum generating device including a vacuum pump used for an adsorption device or the like for grasping an object. There is a known technique of easily separating a cartridge from a main body and replacing it by collectively forming a suction device such as a vacuum pump into a cartridge.

### Citation List

### Patent Document

Patent Document 1: JP 2019-5839 A
Patent Document 2: JP 2000-343471 A

### Summary of Invention

### Technical Problem

When the cartridge is connected to the main body, it is necessary to align or individually connect an air tube for sucking air, a wiring jack, and the like, and therefore replacement work of the cartridge may become cumbersome.

In one respect, an object is to provide a vacuum generating device and an adsorption device capable of easily replacing a vacuum pump.

### Solution to Problem

In one aspect, a vacuum generating device includes a main body and a suction device including a vacuum pump. The suction device is removable from the main body. The main body and the suction device are engaged with each other by an engagement mechanism. The suction device includes a terminal for supplying power to the vacuum pump and a pipe for passing air sucked by operation of the vacuum pump. The main body includes a connector to be connected with the terminal and a connection port to be connected with the pipe. A wiring portion of the suction device and the connector of the main body, and the pipe of the suction device and the connection port of the main body are connected to each other on the same surface as a surface for engagement of the engagement mechanism.

According to one aspect, replacement of the vacuum pump can be easily performed.

### Brief Description of Drawings

[FIG. 1] FIG. 1 is a perspective view illustrating an example of a conveyance system in an embodiment.
[FIG. 2] FIG. 2 is a top view illustrating an example of the conveyance system in the embodiment.
[FIG. 3] FIG. 3 is a perspective view illustrating an example of an adsorption device in the embodiment.
[FIG. 4] FIG. 4 is a perspective view illustrating another example of the adsorption device in the embodiment.
[FIG. 5] FIG. 5 is a cross-sectional view illustrating an example of the adsorption device in the embodiment.
[FIG. 6] FIG. 6 is an exploded perspective view illustrating an example of a vacuum generating device in the embodiment.
[FIG. 7] FIG. 7 is a side cross-sectional view illustrating an example of an attachment attached to a main body in the embodiment.
[FIG. 8] FIG. 8 is an exploded perspective view illustrating an example of a cartridge in the embodiment.
[FIG. 9] FIG. 9 is a perspective view illustrating an example of a cover of the cartridge in the embodiment.
[FIG. 10] FIG. 10 is a perspective view illustrating an example of the cartridge in the embodiment.
[FIG. 11] FIG. 11 is a perspective view illustrating an example of a bottom part of the cartridge in the embodiment.
[FIG. 12] FIG. 12 is a top view illustrating an example of a slot of the main body in the embodiment.
[FIG. 13] FIG. 13 is a cross-sectional view illustrating an example of the adsorption device in the embodiment.
[FIG. 14] FIG. 14 is a cross-sectional view illustrating an example of the main body in the embodiment.
[FIG. 15] FIG. 15 is a cross-sectional view illustrating an example of a first ventilation path in the embodiment.
[FIG. 16] FIG. 16 is a perspective view illustrating an example of the first and second ventilation paths in the embodiment.
[FIG. 17] FIG. 17 is a perspective view illustrating an example of an adsorption device in a first modification.
[FIG. 18] FIG. 18 is a perspective view illustrating an example of an adsorption frame in the first modification.
[FIG. 19] FIG. 19 is a side cross-sectional view illustrating an example of the adsorption device in the first modification.
[FIG. 20] FIG. 20 is a perspective view illustrating an example of a conveyance system in a second modification.
[FIG. 21] FIG. 21 is a side view illustrating another example of the conveyance system in the second modification.
[FIG. 22] FIG. 22 is a view illustrating an example of a cartridge in a third modification.
[FIG. 23] FIG. 23 is a view illustrating an example of a conveyance system including a vacuum generating device in a fourth modification.
[FIG. 24] FIG. 24 is a view illustrating an example of the conveyance system including the vacuum generating device in the fourth modification.

### Description of Embodiments

Hereinafter, an embodiment of a vacuum generating device and an adsorption device disclosed in the present application will be described in detail with reference to the drawings. Note that the dimensional relationship between elements and the ratio of each element in the drawings may differ from reality. Parts having different dimensional relationships and ratios may be included even among the drawings. For easy understanding of the description, each drawing may illustrate a coordinate system. At the coordinate system, a top surface 111 side of a cartridge 100 described later is a positive direction in a Y axis, and the cartridge 100 is mounted at a positive direction side in an X axis and a negative direction side in a Z axis of a main body 500. Note that the same reference signs are assigned to the same components throughout the description of the embodiment.

### [Embodiment]

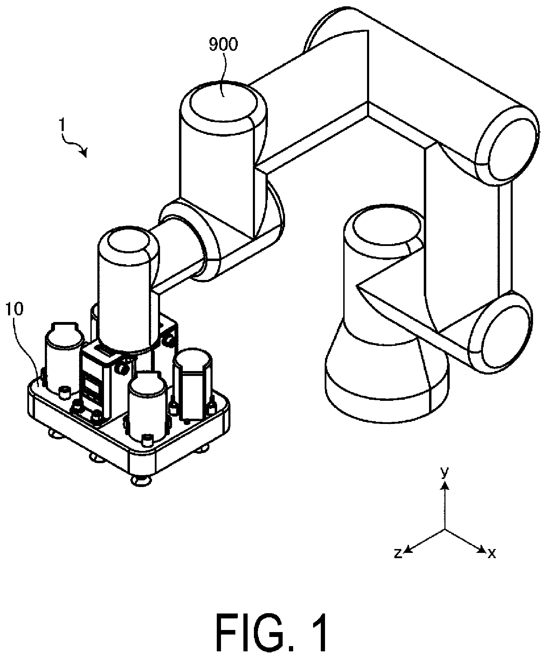

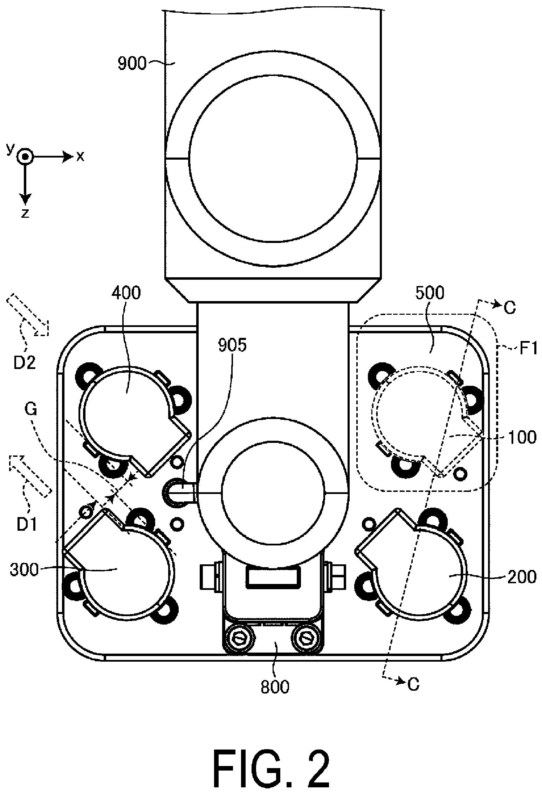

First, a conveyance system in the embodiment will be described with reference to FIGS. 1 and 2. FIG. 1 is a perspective view illustrating an example of a conveyance system in the embodiment. FIG. 2 is a top view illustrating an example of the conveyance system in the embodiment. As illustrated in FIG. 1, a conveyance system 1 in the embodiment includes an adsorption device 10 and a robot arm 900.

The robot arm 900 is, for example, a known vertical articulated robot arm including a plurality of joints, a plurality of arms, and a support part. The robot arm 900 moves the adsorption device 10 mounted to the support part by the plurality of joints rotating or bending and stretching. Note that the robot arm 900 may be a known horizontal articulated robot arm or the like.

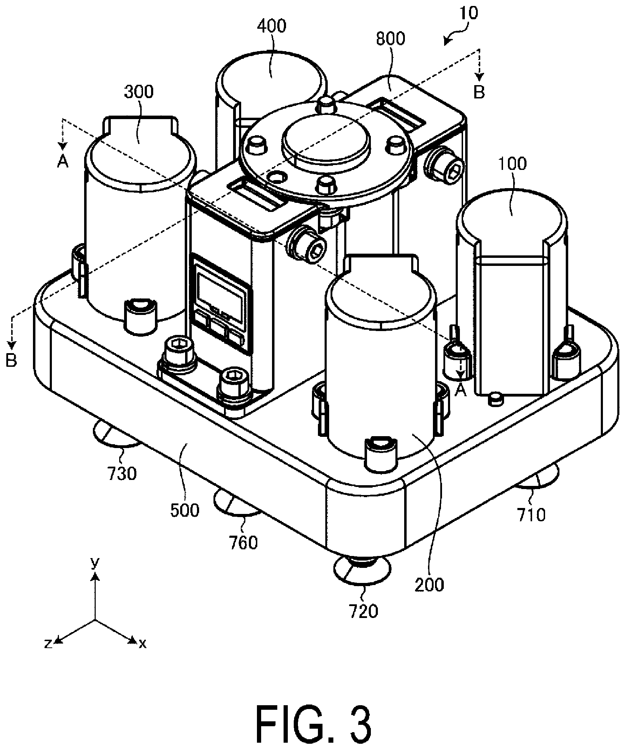

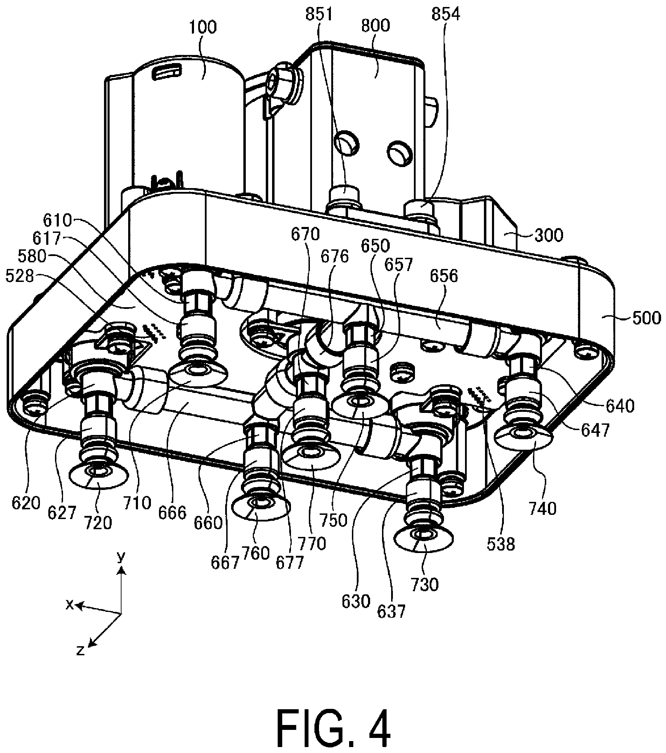

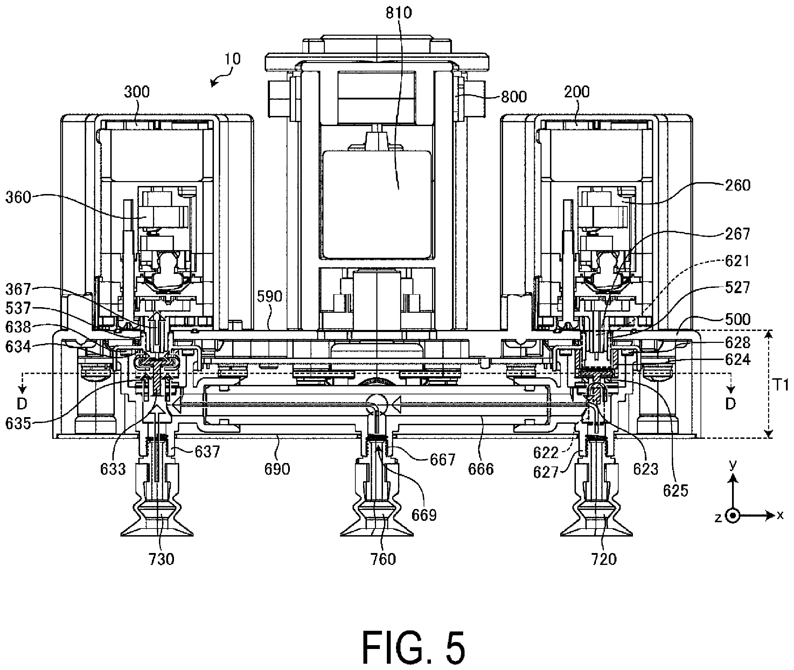

The adsorption device 10 in the embodiment grasps a target object not illustrated by sucking the target object using a vacuum pump. As illustrated in FIGS. 2 to 5, the adsorption device 10 in the embodiment includes the main body 500, cartridges 100 to 400, adsorption pads 710 to 770, and an attachment 800. FIG. 3 is a perspective view illustrating an example of an adsorption device in the embodiment. FIG. 4 is a perspective view illustrating another example of the adsorption device in the embodiment. FIG. 5 is a cross-sectional view illustrating an example of the adsorption device in the embodiment. FIG. 5 illustrates a cross section taken along line A-A in FIG. 3. Note that FIG. 4 omits illustration of a bottom surface 690 of the main body 500 illustrated in FIG. 5 in order to illustrate the internal structure of the main body 500. FIG. 4 illustrates a state. In the state, the cartridges 200 and 400 are not mounted to the main body 500. Note that the cartridges 100 to 400 are examples of a suction device, and the main body 500 is an example of a vacuum control device.

The main body 500 is attached to the robot arm 900 via the attachment 800 as illustrated in FIG. 2. The robot arm 900 and the main body 500 are electrically connected by a cable 905 illustrated in FIG. 2. Note that each of the following drawings may omit illustration of the cable 905 and other components.

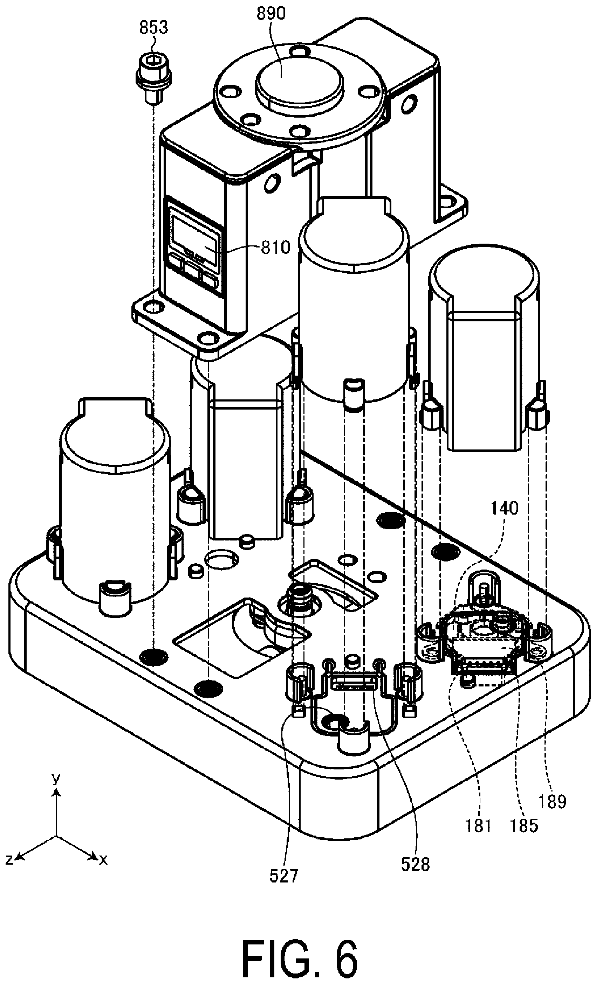

As illustrated in FIGS. 2 and 3, the cartridges 100 to 400 are mounted at the positive direction side in the Y axis direction, that is, an upper surface 590 side of the main body 500 illustrated in FIG. 5. The cartridges 100 to 400 are removable from the main body 500 as illustrated in FIGS. 4 and 6. FIG. 6 is an exploded perspective view illustrating an example of a vacuum generating device in the embodiment. Note that FIG. 6 illustrates, by broken lines, a bottom part 140, a terminal stand 180, and a substrate 189 of the cartridge 100 described later. In the present embodiment, the main body 500 with the cartridges 100 to 400 attached illustrated in FIG. 6 is an example of a vacuum generating device. The adsorption device 10 includes, at the vacuum generating device illustrated in FIG. 6, the adsorption pads 710 to 770 removable from the main body at the negative direction side in the Y axis direction, that is, the bottom surface 690 side of the main body 500 illustrated in FIG. 5.

As illustrated in FIG. 4, ventilation paths 610 to 670 are formed at the main body 500. As described later, the ventilation paths 610 to 640 communicate with connection ports 517 to 547 to be connected to suction holes 167 to 467 of the cartridges 100 to 400, respectively. The ventilation paths 610 to 640 communicate with sockets 617 to 647 with the adsorption pads 710 to 740 connected, respectively. In this case, the socket 617 communicates with the connection port 517 via the ventilation path 610. For example, airtightness of a ventilation path 630 is secured by an O-ring 638 or the like illustrated in FIG. 5. That is, the ventilation path 610 connects the connection port 517 and the adsorption pad 710. As illustrated in FIG. 4, the adsorption pads 750 to 770 are connected to the ventilation paths 650 to 670, respectively. The O-ring 638 or the like may be another sealing member capable of securing airtightness, such as a screw, a gasket, a packing, and a fluorine tape.

As illustrated in FIG. 4, coupling pipes 656 to 676 connecting the ventilation paths 610 to 640 and the ventilation paths 650 to 670 are formed at the main body 500. In the embodiment, the ventilation paths 650 to 670, the parts of the ventilation paths 610 to 640 at the adsorption pads 710 to 740 side, and the coupling pipes 656 to 676 constitute a space brought into a vacuum state. As illustrated in FIG. 4, the main body 500 further includes a substrate 580.

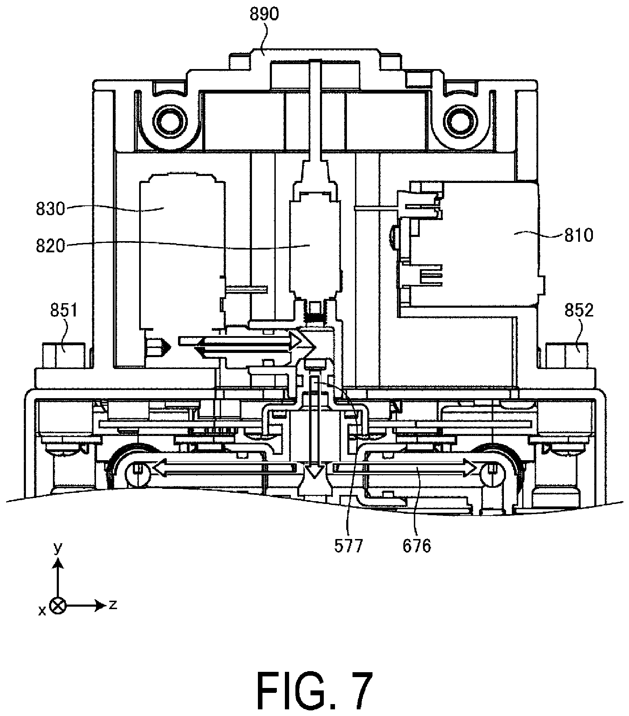

The attachment 800 attaches the main body 500 to an external device such as the robot arm 900. As illustrated in FIG. 7, the attachment 800 includes a display unit 810, a pressure sensor 820, a solenoid valve 830, and an attachment part 890. FIG. 7 is a side cross-sectional view illustrating an example of an attachment attached to a main body in the embodiment. FIG. 7 illustrates a cross section taken along line B-B in FIG. 3.

The attachment 800 is connected to the ventilation path 670 via a connection port 577 illustrated in FIG. 7. The ventilation path 670 is opened to the atmosphere in a case where the solenoid valve 830 is brought into an open state. The display unit 810 displays air pressure in the coupling pipe 676 measured by the pressure sensor 820, for example. Note that the attachment 800 is fixed to the upper surface 590 of the main body 500 by, for example, bolts 851 and 854 illustrated in FIG. 4, a bolt 853 illustrated in FIGS. 3 and 6, and a bolt 852 illustrated in FIG. 3.

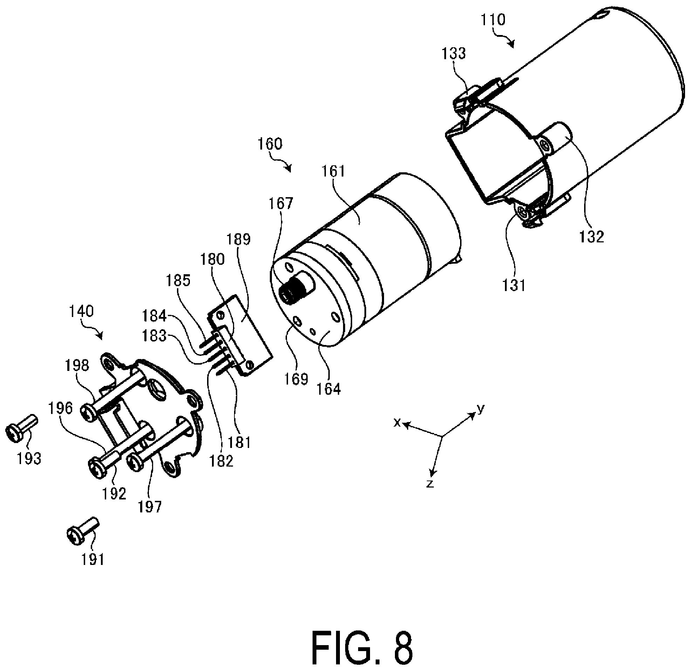

The air in the main body 500 is sucked by a vacuum pump 160 included in the cartridge 100 illustrated in FIG. 8. FIG. 8 is an exploded perspective view illustrating an example of a cartridge in the embodiment. Note that the cartridges 100 to 400 in the embodiment have the same structure, and therefore the structure of the cartridge 100 will be described below. In a case where the components of the cartridge 200, 300, or 400 are particularly distinguished and expressed, for example, as in a vacuum pump 260 of the cartridge 200 and a vacuum pump 360 of the cartridge 300 illustrated in FIG. 5, they are indicated by reference signs as 2nn, 3nn, or 4nn, respectively.

As illustrated in FIG. 8, the cartridge 100 in the embodiment includes a cover 110, the bottom part 140, the vacuum pump 160, the terminal stand 180, and the substrate 189. The vacuum pump 160 is accommodated in the cover 110 and the bottom part 140 in a state of being fixed to the bottom part 140 by bolts 196 to 198 illustrated in FIG. 8.

The vacuum pump 160 includes a side surface 161 and a bottom surface 164. The bottom surface 164 includes a suction hole 167 and an emission hole 169 illustrated in FIG. 8. The vacuum pump 160 sucks air from the suction hole 167 and emits air from the emission hole 169 by, for example, a motor rotating an impeller or the like. Note that the suction hole 167 is an example of a pipe. Through the pipe, air sucked by the operation of the vacuum pump passes, and the side surface 161 is an example of an outer wall of the vacuum pump.

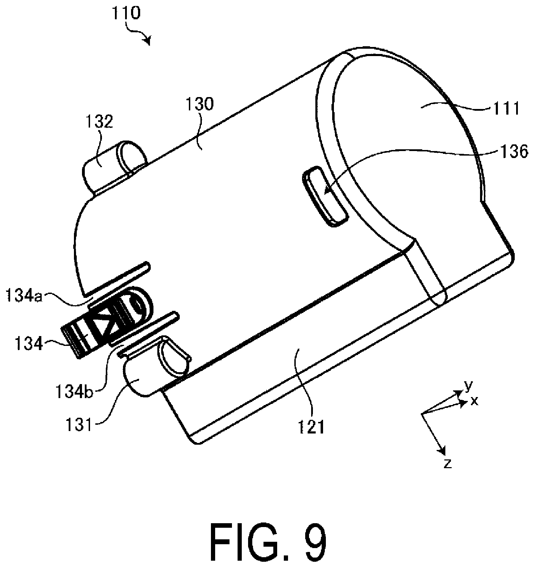

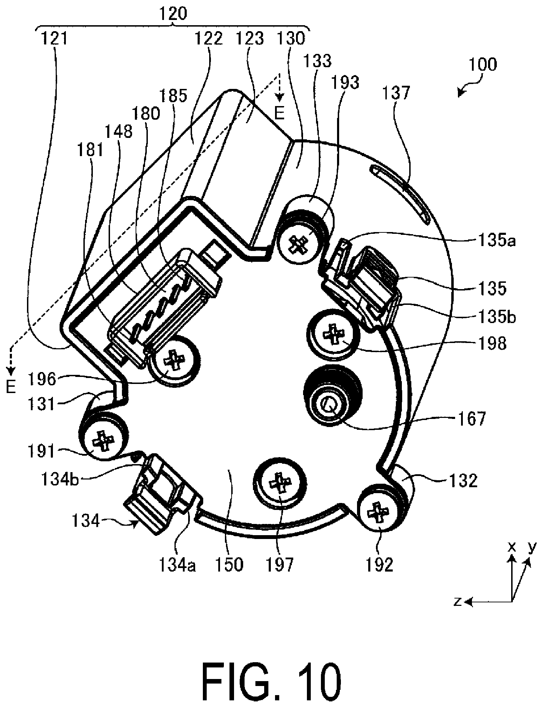

The cover 110 includes the top surface 111 illustrated in FIG. 9 and a side surface 120 illustrated in FIG. 10. FIG. 9 is a perspective view illustrating an example of a cover of the cartridge in the embodiment. FIG. 10 is a perspective view illustrating an example of the cartridge in the embodiment. The top surface 111 is formed at a position opposed to the bottom part 140 in the Y axis direction.

As illustrated in FIG. 10, the side surface 120 of the cover 110 includes flat surfaces 121, 122, and 123 and a curved surface 130. The flat surfaces 121 and 123 project outward in the radial direction, that is, toward a direction intersecting the direction of mounting to the main body 500. In this case, the flat surfaces 121, 122, and 123 form a part projecting outward in the radial direction, that is, a part projecting in a direction intersecting the direction of mounting the cartridge 100 to the main body 500. Note that the flat surfaces 121, 122, and 123 are examples of inner walls of the projecting part.

The curved surface 130 of the cover 110 includes boss parts 131 to 133 projecting outward in the radial direction. As illustrated in FIGS. 8 and 10, the boss parts 131 to 133 are fixed to the bottom part 140 by bolts 191 to 193, respectively.

A pair of claw parts 134 and 135 are formed on the curved surface 130. As illustrated in FIGS. 6 and 9, the claw parts 134 and 135 project at the negative direction side in the Y axis relative to the bottom part 140. As illustrated in FIGS. 9 and 10, slits 135a and 135b are formed at both sides of the claw part 135 in the circumferential direction. Slits 134a and 134b are also formed at the claw part 134 as illustrated in FIG. 10. Note that the number of claw parts is not limited to one pair, and other claw parts may be formed other than the claw parts 134 and 135.

A pair of exhaust ports 136 and 137 are formed on the curved surface 130 at the top surface 111 side in the Y axis direction as illustrated in FIGS. 9 and 10, respectively. Note that the exhaust ports 136 and 137 are examples of the second openings formed at the top surface side.

As illustrated in FIG. 8, the terminal stand 180 holds terminals 181 to 185 electrically connecting the main body 500 and the cartridge 100. The substrate 189 electrically connects an external power source (not illustrated) and the vacuum pump 160 via the terminals 181 to 185.

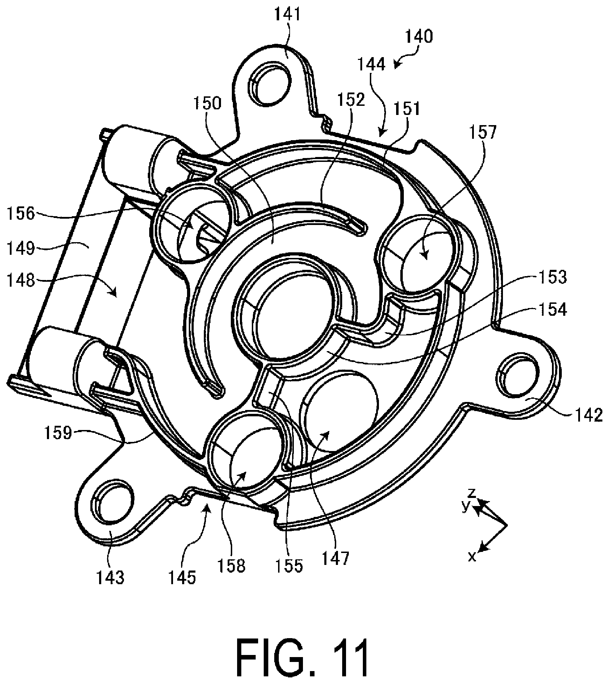

In the embodiment, as illustrated in FIG. 11, projecting parts 141 to 143 are formed at the bottom part 140 at positions opposed to the boss parts 131 to 133 of the cover 110. FIG. 11 is a perspective view illustrating an example of a bottom part of the cartridge in the embodiment. The projecting parts 141 to 143 have through holes formed. Through the through holes, the bolts 191 to 193 are inserted, respectively. Furthermore, as illustrated in FIG. 11, the bottom part 140 has through holes 156 to 158 formed. Through the through holes 156 to 158, the bolts 196 to 198 are inserted.

The bottom part 140 includes a bottom surface 150 and sidewalls 151 to 155 and 159 projecting toward the positive direction side in the Y axis direction and extending in a direction intersecting the Y axis direction. Note that the sidewalls 151 to 155 and 159 are examples of wall parts.

As illustrated in FIG. 11, recess parts 144 and 145 are formed at the bottom part 140 at positions corresponding to the claw parts 134 and 135 of the cover 110, respectively. The claw parts 134 and 135 of the cover 110 can be elastically deformed inward in the radial direction by the slits 134a, 134b, 135a, and 135b and the recess parts 144 and 145 of the bottom part 140.

The bottom part 140 includes a through hole 148 and a support part 149 supporting the substrate 189. The terminal stand 180 is inserted through the through hole 148. In the embodiment, the support part 149 is disposed at a part projecting outward in the radial direction. By this, the substrate 189 is disposed at the projecting part. Furthermore, the bottom part 140 has a through hole 147 formed. The suction hole 167 is inserted through the through hole 147. Note that the through hole 147 is an example of a first opening formed on the bottom surface.

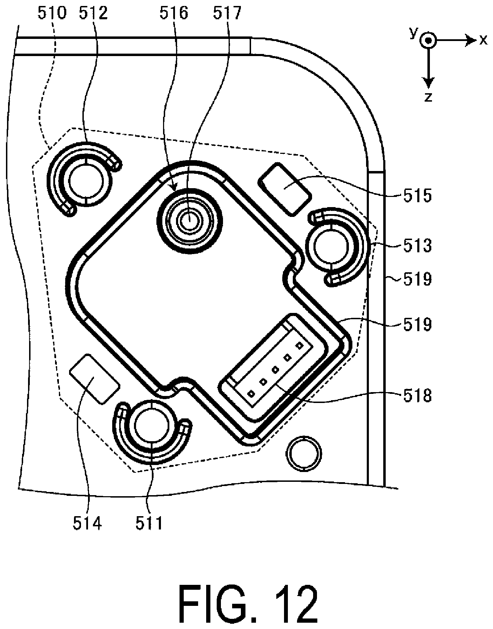

As illustrated in FIG. 12, the upper surface 590 of the main body 500 has a slot 510 formed. The cartridge 100 is mounted to the slot 510. FIG. 12 is a top view illustrating an example of a slot of the main body in the embodiment. FIG. 12 is an enlarged view of a part indicated by a frame F1 of the main body 500 illustrated in FIG. 2. Note that slots 520 to 540 having the cartridges 200 to 400 respectively mounted also have the same configuration as the slot 510, the description regarding each slot is also applied to other slots unless otherwise specified.

As illustrated in FIG. 12, the slot 510 includes support walls 511 to 513, engaged parts 514 and 515, the connection port 517, and a connector 518. As illustrated in FIG. 12, for example, the engaged parts 514 and 515 are through holes formed on the upper surface 590 of the main body 500, and are formed at positions opposed to the claw parts 134 and 135 of the cartridge 100. The connector 518 is connected to the substrate 580 illustrated in FIG. 4, for example. The connection port 517 is connected to the ventilation path 610 illustrated in FIG. 4.

The claw parts 134 and 135 of the cartridge 100 are inserted into the engaged parts 514 and 515 formed on the upper surface 590 of the main body 500, respectively, in a state of being elastically deformed inward in the radial direction. Thereafter, the claw parts 134 and 135 return to the outside in the radial direction, whereby the claw parts 134 and 135 are engaged with the engaged parts 514 and 515, respectively. By this, the cartridge 100 is mounted to the main body 500. In this case, the support walls 511 to 513 serve as guide parts for aligning the boss parts 131 to 133.

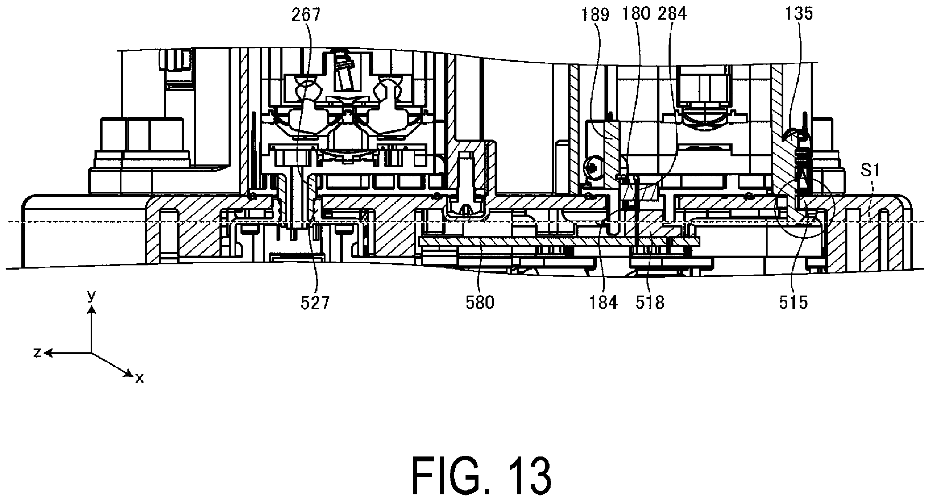

As illustrated in FIG. 13, a tip end part of the claw part 135 of the cartridge 100 extends at the negative direction side in the Y axis direction and engages with the engaged part 515 of the slot 510 illustrated in FIG. 12. FIG. 13 is a cross-sectional view illustrating an example of the adsorption device in the embodiment. FIG. 13 illustrates a cross section taken along line C-C in FIG. 2. That is, the cartridge 100 and the main body 500 are engaged with each other by the claw part 135 and the engaged part 515. Note that the claw part 135 and the engaged part 515 constitute an engagement mechanism. The same applies to the claw part 134 and the engaged part 514 not illustrated in FIG. 13. Note that the engagement mechanism is not limited to one using a claw, and may be engaged by screwing, for example.

At this time, the terminal 184 of the cartridge 100 extends at the negative direction side in the Y axis direction and is connected to the connector 518 as illustrated in FIG. 13. The same applies to the terminals 181 to 183 and 185 not illustrated in FIG. 13. As illustrated in FIG. 13, when the cartridge 200 is mounted to the slot 520, a suction hole 267 projecting at the negative direction side in the Y axis is inserted into the connection port 527 of the main body 500. In this case, the terminal 184 of the cartridge 100 and the connector 518 of the main body 500, and the suction hole 267 of the cartridge 200 and the connection port 527 of the main body 500 are connected to each other on the same surface as a surface S1 illustrated in FIG. 13. The claw part 134 and the engaged part 514 constituting the engagement mechanism are engaged on the surface S1.

Also at the cartridge 100, the terminals 181 to 185, the suction hole 167, and the claw parts 134 and 135, parts of the engagement mechanism, extend in the same direction. The terminals 181 to 185 of the cartridge 100 and the connector 518 of the main body 500, and the suction hole 167 of the cartridge 100 and the connection port 517 of the main body 500 not illustrated in FIG. 13, are connected to each other on the same surface as the surfaces. At the surfaces, the claw parts 134 and 135 and the engaged parts 514 and 515 are engaged. Each of the claw parts 134 and 135 is the engagement mechanism. By this, it is not necessary to align a plug 167, the terminals 181 to 185, and the like, and the cartridge 100 can be easily mounted to the main body 500.

As illustrated in FIG. 12, the slot 510 of the main body 500 includes a seal packing 519. At the upper surface 590, the connection port 517 and the connector 518 are surrounded by the seal packing 519. That is, in a state where the cartridge 100 is mounted to the main body 500, the seal packing 519 surrounds the terminals 181 to 185, the connector 518, the suction hole 167, and the connection port 517. According to such a configuration, propagation of vibration between the cartridge 100 and the main body 500 is suppressed, and foreign matter intrusion and water ingress into the slot 510 are suppressed, and therefore durability of the connection part between the cartridge 100 and the slot 510 can be improved.

The slots 510, 520, 530, and 540 are formed on the upper surface 590 of the main body 500 so as to surround the attachment 800. In the embodiment, the slot 540 is formed in a direction different from the slot 530 as illustrated in FIG. 2. The cartridge 300 adjacent to the cartridge 400 is mounted to the slot 540. In this case, the cartridges 300 and 400 adjacent to each other are mounted to the main body 500 such that the projecting parts respectively face different directions. That is, as illustrated in FIG. 2, the projecting part of the cartridge 300 faces the negative direction side in the X axis and the negative direction side in the Z axis direction (direction D1), whereas the projecting part of the cartridge 400 faces the positive direction side in the X axis and the positive direction side in the Z axis direction (direction D2). The same applies to the cartridges 100 and 200.

According to such a configuration, for example, as indicated by an arrow in FIG. 2, a gap G between the cartridges 300 and 400 becomes large. By this, for example, even in a state where the adsorption device 10 is mounted to the robot arm 900, it becomes easy to put a finger into the gap between the cartridges to hold the cartridge, and therefore it is possible to easily attach and detach the cartridges 100 to 400.

As illustrated in FIG. 4, for example, the adsorption device 10 in the embodiment is operable even in a state where any one or more of the cartridges 100 to 400 are not mounted. The cartridges 100 to 400 are also controllable independently of the operation of the other cartridges. For example, FIG. 5 illustrates a state. In the state, the vacuum pump 360 of the cartridge 300 is operating but the vacuum pump 260 of the cartridge 200 is stopped. The control of the flow of the air in this case will be described below.

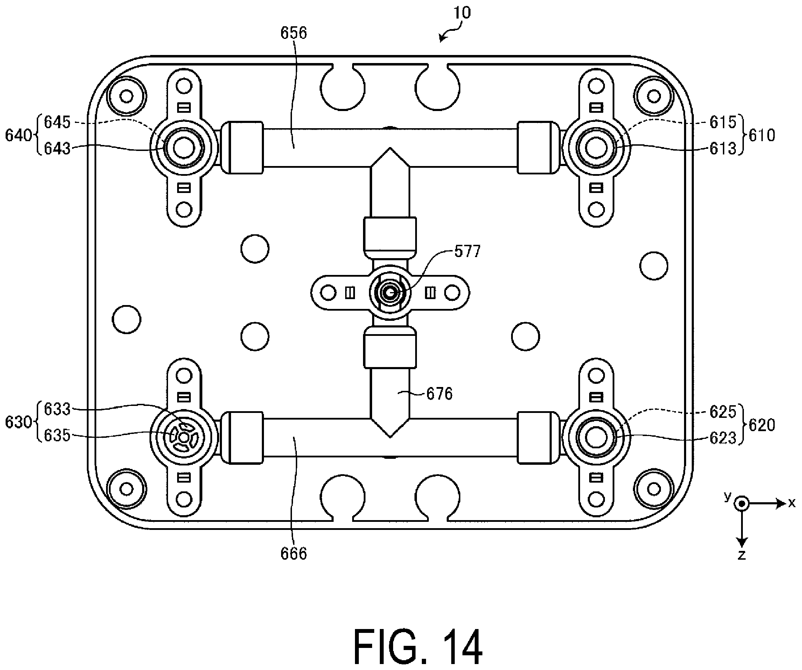

As illustrated in FIGS. 5 and 14, a ventilation port 635 and a check valve 633 are disposed in the ventilation path 630. The check valve 633 switches an open state and a closed state of the ventilation port 635. The air sucked by the cartridge 300 passes through the ventilation path 630. FIG. 14 is a cross-sectional view illustrating an example of the main body in the embodiment. FIG. 14 illustrates a cross section taken along line D-D in FIG. 5. Similarly, as illustrated in FIG. 14, check valves 613, 623, and 643 and ventilation ports 615, 625, and 645 are disposed at the ventilation paths 610, 620, and 640, respectively. As illustrated in FIG. 5, the ventilation path 620 includes a spring 624, and the ventilation path 630 includes a spring 634. Note that in FIG. 14, the ventilation ports 615, 625, and 645 are covered with the check valves 613, 623, and 643, respectively, and are not visually recognized. Note that FIG. 14 omits illustration of the substrate 580.

As illustrated in FIG. 5, the check valve 623 in the embodiment is biased by the spring 624 at the negative direction side in the Y axis direction, that is, in the direction of closing the ventilation port 625. Note that the spring 624 is an example of a biasing member. That is, in the embodiment, the main body 500 includes the biasing member 624 for biasing the check valve 623 in a direction of closing the check valve 623. In this state, the air sucked from the adsorption pad 720 is blocked by the check valve 623 as indicated by an arrow in FIG. 5. Note that the biasing member is not limited to a spring, and may be another member such as rubber, magnet, shape memory alloy, or disc type bimetal (thermal expansion valve). For example, the disc type bimetal is appropriately applicable according to the temperature of the gas to be sucked.

On the other hand, as illustrated in FIG. 5, the air in the ventilation path 630 is sucked by the cartridge 300, whereby the check valve 633 moves at the positive direction side in the Y axis direction, that is, in a direction of opening the ventilation port 635. That is, in the embodiment, the check valve 633 is brought into a closed state in a state where the vacuum pump 360 of the cartridge 300 connected to the connection port 537 is stopped, and is brought into an open state during the operation of the vacuum pump 360. In this case, in addition to the air sucked from the adsorption pad 730, the air sucked from the adsorption pads 720 and 760 is also sucked from the connection port 537 to the cartridge 300 via the coupling pipe 666 as illustrated in FIG. 5.

In a case where the cartridge 300 stops operating, the check valve 633 returns to the closed state by the biasing force of the spring 634. In such a configuration, the check valve 633 maintains the closed state also after the cartridge 300 is removed. That is, in a state where the adsorption pads 710 to 770 are sucking the target object, the vacuum state inside the main body 500 is maintained also after the vacuum pump 360 stops the operation, and also in a state where the cartridge 300 is removed, and therefore it is possible to suppress falling of the target object.

In the embodiment, the other vacuum pump 260 is connected to the other connection port 527 other than the connection port 537. In this case, the check valve 633 connected to the connection port 537 is operable independently of the other check valves 623. For example, also when the vacuum pump 260 of the cartridge 200 is stopped and the check valve 623 is in a closed state, in a state where the vacuum pump 360 of the cartridge 300 is operating, the other check valve 633 may be brought into an open state. That is, the check valve 623 operates independently of the operation of the vacuum pump connected to another check valve.

In the embodiment, as illustrated in FIG. 5, the adsorption pad 730, the check valve 633, and the connection port 537 are disposed in a straight line. According to such a configuration, the structure of the ventilation path 630 of the main body 500 can be simplified, and a thickness T1 of the main body 500 illustrated in FIG. 5 can be reduced.

As illustrated in FIG. 5, the check valve 623 in the closed state divides the ventilation path 620 into a first space 621 and a second space 622. That is, the ventilation path 620 includes the first space 621 formed between the check valve 623 and the connection port 527, and the second space 622 formed between the check valve 623 and the adsorption pad 720. In this case, the check valve 623 maintains the closed state regardless of the air pressure of the second space 622. The first space 621 is not included in the space brought into the vacuum state.

In such a configuration, the vacuum state of the second space 622 is released by the operation of the solenoid valve 830 of the attachment 800. Specifically, when the solenoid valve 830 connected to the second space 622 via the coupling pipes 666 and 676 and the connection port 577 shifts from the closed state to the open state, the second space 622 in the vacuum state is released to the atmosphere. According to such a configuration, since the vacuum state can be released without operating the individual check valves 613 to 643, the structure can be simplified, and the power consumption accompanying the opening of the vacuum state can be saved. In particular, in a case of using a plurality of vacuum pumps, it is possible to reduce the weight of the main body by reducing the number of solenoid valves (e.g., reducing the number of vacuum pumps).

The air sucked out by the vacuum pump 160 of the cartridge 100 is emitted from the emission hole 169 of the vacuum pump 160 illustrated in FIG. 8. When emitted from the exhaust ports 136 and 137 formed on the cover 110, the emitted air passes through the first ventilation path formed by the sidewalls 151 to 155 and 159 of the bottom part 140.

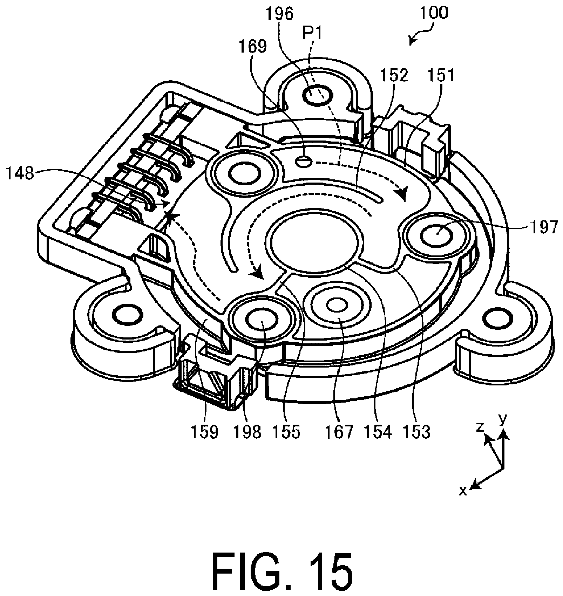

As illustrated in FIG. 15, the sidewalls 151 to 155 and 159 illustrated in FIG. 11 form a first ventilation path P1 with a plurality of continuous arcs. FIG. 15 is a cross-sectional view illustrating an example of a first ventilation path in the embodiment. FIG. 15 illustrates a cross section taken along line E-E in FIG. 10. As illustrated in FIG. 15, the first ventilation path P1 continues, while repeatedly folding back, from the emission hole 169 of the vacuum pump 160 to the through hole 148. The terminal stand 180 is disposed in the through hole 148.

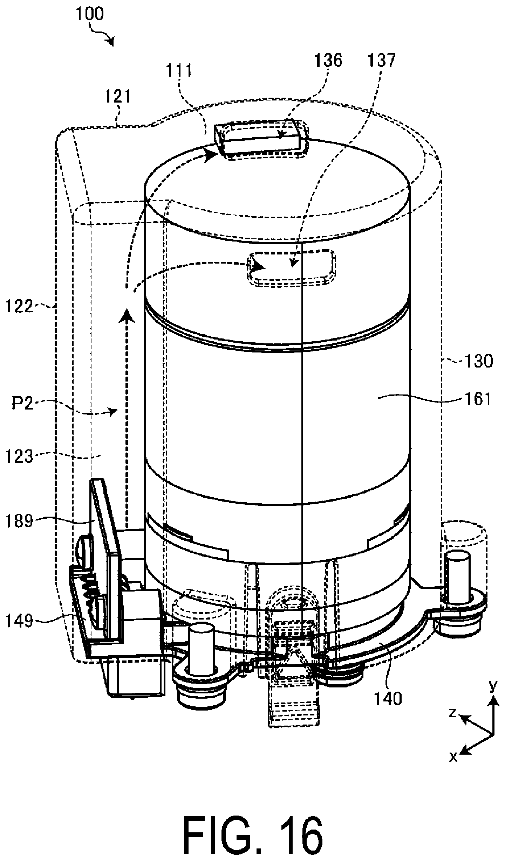

As illustrated in FIG. 16, the first ventilation path P1 is formed by the bottom surface 150 and the sidewalls 151 to 155 and 159 of the bottom part 140 and the bottom surface 164 of the vacuum pump 160. FIG. 16 is a perspective view illustrating an example of the first and second ventilation paths in the embodiment. Then, as indicated by an arrow in FIG. 16, the air emitted from the first ventilation path P1 passes through a second ventilation path P2 leading to the exhaust ports 136 and 137 while being in contact with the substrate 189 in the support part 149. At this time, the air is emitted from the exhaust ports 136 and 137 while being in contact with the side surface 161 of the vacuum pump 160 and the flat surfaces 121, 122, and 123 and the curved surface 130 of the cover 110. That is, as illustrated in FIG. 16, the second ventilation path P2 is formed by the inner walls 121, 122, and 123 of the projecting part and the outer wall 161 of the vacuum pump 160.

According to such a configuration, the path until the air emitted from the emission hole 169 is emitted to the outside of the cartridge 100 can be lengthened, and therefore the exhaust noise can be attenuated. The substrate 189 is disposed at the exhaust passage and the exhaust gas is emitted along the side surface 161 of the vacuum pump 160, whereby the exhaust gas can be utilized for cooling the vacuum pump 160 and the substrate 189.

As described above, the vacuum generating device in the embodiment includes the main body 500 and the cartridge 100 including the vacuum pump 160. The cartridge 100 is removable from the main body 500. The main body 500 and the cartridge 100 are engaged with each other by the engagement mechanisms 134, 135, 514, and 515. The cartridge 100 includes the terminals 181 to 185 for supplying power to the vacuum pump 160 and the pipe 167. The air sucked by the operation of the vacuum pump 160 passes through the pipe 167. The main body 500 includes the connector 518 and the connection port 517. The terminals 181 to 185 are connected to the connector 518. The pipe 167 is connected to the connection port 517. The terminals 181 to 185 of the cartridge 100 and the connector 518 of the main body 500, and the pipe 167 of the cartridge 100 and the connection port 517 of the main body 500 are connected to each other on the same surface as the surface S1. The engagement mechanisms 134, 135, 514, and 515 are engaged on the surface S1. According to such a configuration, replacement of the vacuum pump can be easily performed.

The vacuum control device 500 in the embodiment includes the connection port 527, the ventilation paths 621, 622, and 625, and the check valve 623. The connection port 527 is connected to the vacuum pump 260 and air sucked by the operation of the vacuum pump 260 passes through the connection port 527. The ventilation paths 621, 622, and 625 are continuous with the connection port 527 and the adsorption pad 720 is connected to the ventilation paths 621, 622, and 625. The check valve 623 is disposed at the ventilation path 621 and switches between an open state and a closed state of the ventilation path 625. The check valve 623 is brought into a closed state in a state where the vacuum pump 260 is stopped, and is brought into an open state during the operation of the vacuum pump 260. According to such a configuration, the structure of the device can be simplified.

The suction device 100 in the embodiment includes the vacuum pump 160, the bottom part 140, the top surface 111 formed at a position opposed to the bottom part 140 in the axial direction, the first opening 147 formed at the bottom part 140, and the second openings 136 and 137 formed on the top surface 111 side in the axial direction. The first ventilation path P1 is formed at the bottom part 140, and the second ventilation path P2 is formed between the bottom part 140 and the second openings 136 and 137. Sucked air passes through the first ventilation path P1 and the second ventilation path P2 and is emitted from the second openings 136 and 137. According to such a configuration, noise due to exhaust or the like of the vacuum pump can be reduced.

### [Modification]

Although the configuration of each embodiment has been described above, the embodiment is not limited to this. For example, an example has been described. In the example, the adsorption device 10 is mounted to the robot arm 900 for performing bending and stretching operation and rotating operation as illustrated in FIG. 1. However, it is not limited to this, and for example, the adsorption device may be mounted to a robot arm for performing expanding and contracting operation, or may be formed movably along a rail. The adsorption device may be configured not to be mounted to a robot arm, a rail, or the like, and for example, the adsorption device may be configured to be moved by the operator manually holding it.

The check valve in the embodiment is also applicable to an adsorption device including a vacuum pump not the cartridge 100. The shape of the bottom part 140 of the cartridge 100 may also be applied to a vacuum pump other than the cartridge 100.

A configuration has been described. In the configuration, the adsorption pads 710 to 770 having the same shape are mounted to all the sockets 617 to 677. However, a configuration may be adopted. In the configuration, the adsorption pads 710 to 770 are also detachable, and the adsorption pads are not mounted to any one or a plurality of sockets. A configuration may be adopted. In the configuration, the adsorption pads having different shapes are mounted respectively to a plurality of sockets. Note that the adsorption pads 710 to 770 may be connected to the sockets 617 to 677 via a fall prevention valve not illustrated, for example.

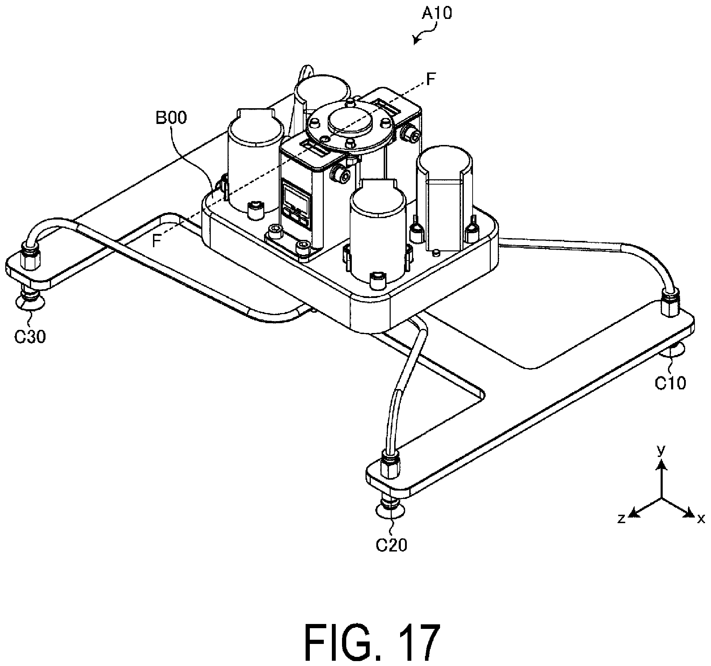

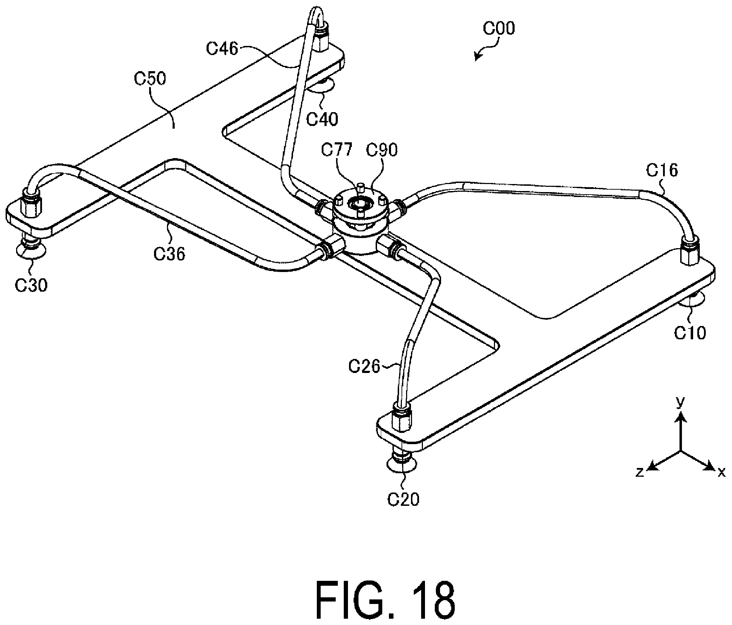

As illustrated in FIG. 17, an adsorption frame C00 including a plurality of adsorption pads as illustrated in FIG. 18 may be mounted to any one or a plurality of the sockets 617 to 677. FIG. 17 is a perspective view illustrating an example of an adsorption device in the first modification. FIG. 18 is a perspective view illustrating an example of an adsorption frame in the first modification. Note that in each of the following modifications, the same parts as the parts illustrated in the previously described drawings are given the same reference signs, and overlapping descriptions are omitted.

As illustrated in FIG. 18, the adsorption frame C00 in the first modification includes adsorption pads C10 to C40 attached to a frame C50. The adsorption pads C10 to C40 are connected to a connection port C77 formed at an attachment part C90 via ventilation paths C16 to C46, respectively.

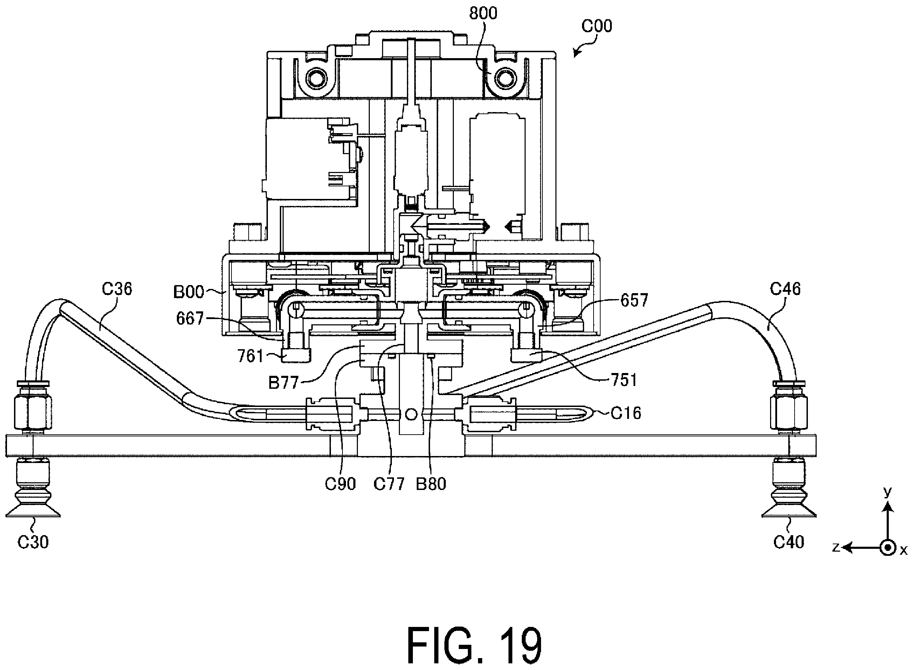

As illustrated in FIG. 19, a main body B00 of an adsorption device A10 in the first modification is different from the main body 500 in the embodiment in including an adsorption frame connection part B77 in place of the socket 677. FIG. 19 is a side cross-sectional view illustrating an example of the adsorption device in the first modification. FIG. 19 illustrates a cross section taken along line F-F in FIG. 17. The attachment part C90 of the adsorption frame C00 illustrated in FIG. 18 is attached to the adsorption frame connection part B77. An O-ring B80 or the like keeps airtightness between the adsorption frame connection part B77 and the connection port C77 of the adsorption frame C00.

As illustrated in FIG. 19, rubber plugs 751 and 761 are mounted to the other sockets 657 and 667 having the adsorption frame C00 not connected, whereby air is suppressed from leaking from the inside of the main body B00. The same applies to the sockets 617 to 647 not illustrated in FIG. 19.

As illustrated in FIG. 17, a gap between the adsorption pad C20 and the adsorption pad C30 in the X axis direction is larger than the size of the main body B00 in the X axis direction. A gap between the adsorption pad C10 and the adsorption pad C20 in the Z axis direction is larger than the size of the main body B00 in the Z axis direction. According to such a configuration, a larger target object can be adsorbed.

As described above, the adsorption device A10 in the first modification includes the adsorption pads C10 to C40 removable from the main body B00. The adsorption pads C10 to C40 may be mounted to the adsorption frame C00. According to such a configuration, the number and disposition of adsorption pads can be easily changed according to the size and weight of the target object.

Note that a configuration has been described. In the configuration, the adsorption frame connection part B77 is included in place of the socket 677. However, a configuration may be adopted. In the configuration, the adsorption frame connection part B77 is mounted to the socket 677. The socket having the adsorption frame connection part B77 attached is not limited to the socket 677, and the adsorption frame connection part B77 may be mounted to one or a plurality of other sockets.

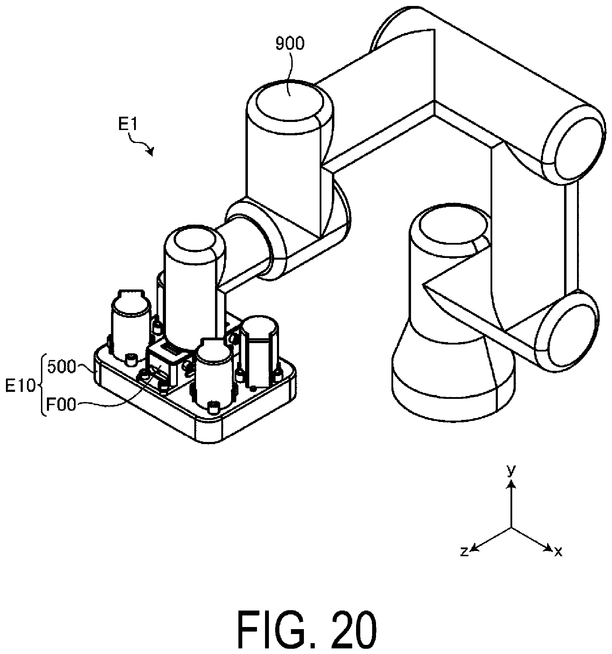

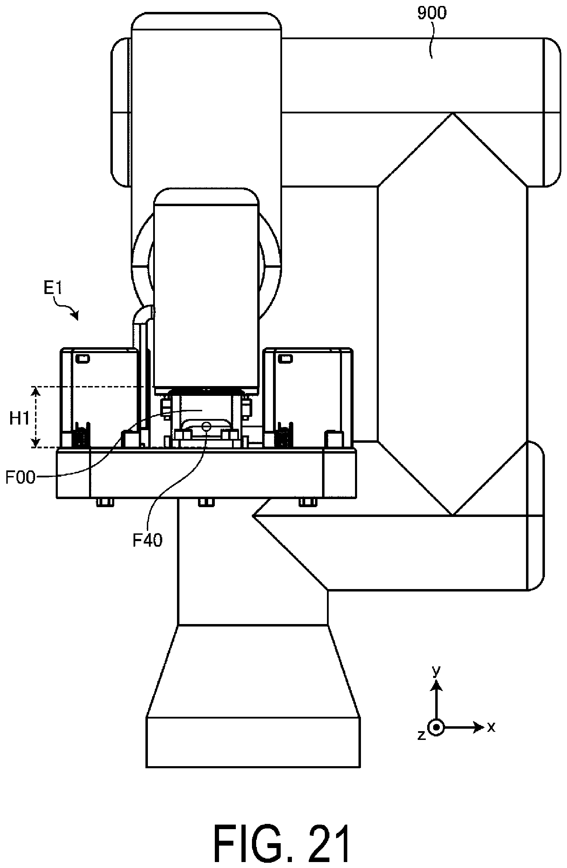

A configuration has been described. In the configuration, the attachment 800 includes the display unit 810, the pressure sensor 820, the solenoid valve 830, and the attachment part 890. However, it is not limited to this, and a configuration may be adopted. In the configuration, the solenoid valve 830 and the like are provided outside as illustrated in FIGS. 20 and 21. FIG. 20 is a perspective view illustrating an example of a conveyance system in the second modification. FIG. 21 is a side view illustrating another example of the conveyance system in the second modification. Note that FIG. 21 illustrates a state. In the state, the cartridges 200 and 400 are not mounted to the main body 500.

As illustrated in FIG. 20, in a conveyance system E1 in the second modification, an adsorption device E10 includes the main body 500 and an attachment F00. The cartridges 100 to 400 are mounted to the main body 500. As illustrated in FIG. 21, the attachment F00 in the second modification includes a connection part F40 in place of the display unit 810, the pressure sensor 820, and the solenoid valve 830. The connection part F40 is a part connecting the attachment F00 and, for example, an external solenoid valve (not illustrated). A configuration may be adopted. In the configuration, an external display unit (not illustrated) or a pressure sensor (not illustrated) is connected to the connection part F40.

As illustrated in FIG. 21, a height H1 of a top surface of the attachment F00 in the Y axis direction in the second modification is smaller than a height of the cartridge 100 in the Y axis direction. According to such a configuration, the attachment center of gravity between the robot arm 900 and the adsorption device E10 can be lowered, and therefore portability (load capable of being lifted by the robot. Weight for satisfying the specifications in use) of the conveyance system E1 can be improved.

The shape of the cartridge 100 is also an example, and a configuration not including the boss parts 131 to 133 and the flat surfaces 121, 122, or 123 may be adopted. For example, a configuration may be adopted. In the configuration, a cartridge not including the boss parts 131 to 133 is welded to the main body.

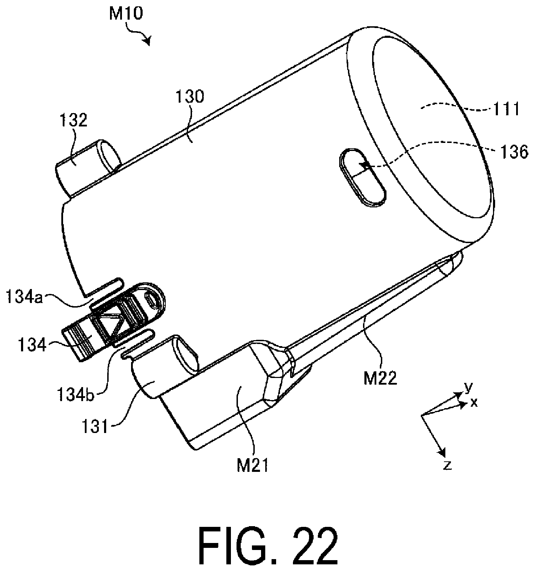

As illustrated in FIG. 22, the shape of a part constituting the second ventilation path may be different. FIG. 22 is a view illustrating an example of a cartridge in the third modification. A cover M10 of the cartridge illustrated in FIG. 22 includes an accommodation part M21 and a ventilation part M22 projecting outward in the radial direction. The terminal stand 180 and the substrate 189 illustrated in FIG. 8 are accommodated in the accommodation part M21. The ventilation part M22 forms the second ventilation path leading to the exhaust ports 136 and 137.

The shape of a projecting part formed by the flat surfaces 121, 122, and 123 as illustrated in FIGS. 8 to 10 is also an example, and may be the shape as illustrated in FIG. 22. FIG. 22 is a view illustrating another example of the cartridge in the third modification. As illustrated in FIG. 22, the shape of the accommodation part M21 accommodating the substrate 189 and the terminal stand 180 and the shape of the ventilation part M22 forming the second ventilation path may be different.

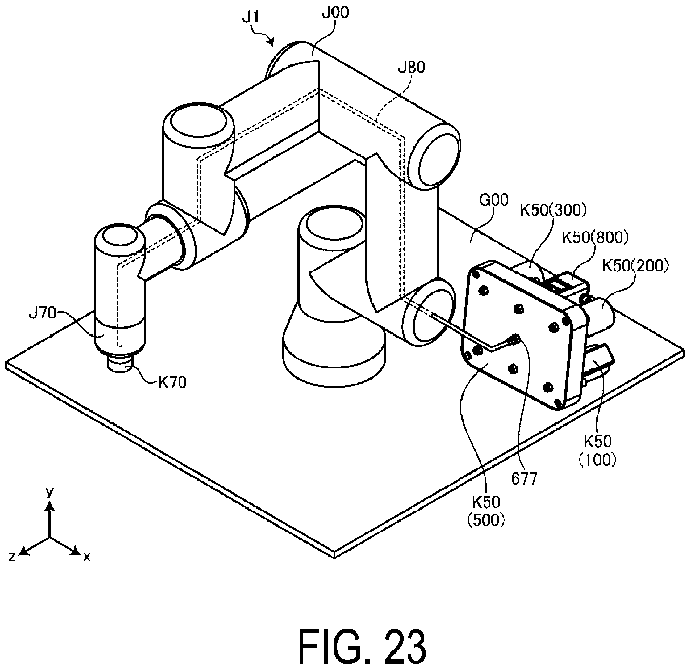

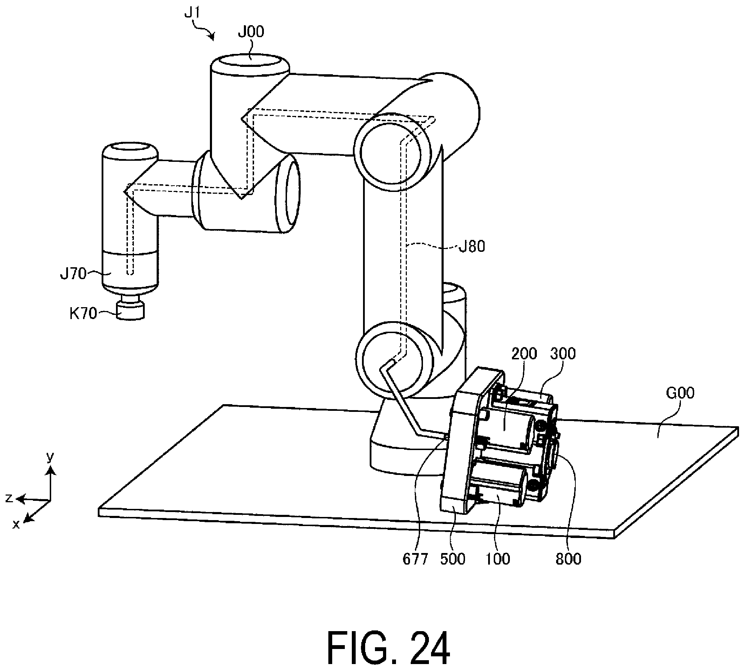

The vacuum generating device having the cartridges 100 to 400 mounted to the main body 500 need not be attached to a robot arm as illustrated in FIGS. 23 and 24 as long as suction via an adsorption pad is possible. FIGS. 23 and 24 are views illustrating examples of the conveyance system including the vacuum generating device in the fourth modification. As illustrated in FIGS. 23 and 24, a vacuum generating device K50 in the fourth modification includes the cartridges 100 to 400, the main body 500, and the attachment 800. A vacuum air pipe J80 is connected to the socket 677 of the vacuum generating device K50.

As illustrated in FIGS. 23 and 24, regarding the vacuum generating device K50, the side surface of the main body 500 and the top part of at least any one of the cartridges 100 to 400 are in contact with a ground surface G00. This can stabilize the vacuum generating device K50. Note that the top part of the attachment 800 may be configured to come into contact with the ground surface G00.

In a robot arm J00 in the fourth modification, the vacuum air pipe J80 connecting the vacuum generating device K50 and an adsorption pad K70 is formed. As illustrated in FIGS. 22 and 23, the vacuum air pipe J80 is formed inside the robot arm J00, for example. Note that the vacuum air pipe J80 may be formed outside (side surface) or the like of the robot arm J00, for example. In such a configuration, the adsorption pad K70 is attached to an attachment part J70 of the robot arm J00.

According to the conveyance system J1, weight reduction of the tip end part of the robot arm J00 can be further achieved, portability can be further improved.

The cartridge and the vacuum generating device described in each embodiment and each modification can also be used for vacuuming of other apparatuses such as semiconductor manufacturing equipment and a vacuum molding apparatus in addition to the adsorption device described in the embodiment and each modification.

Although the present invention has been described above based on the embodiment and each modification, the present invention is not limited to the embodiment and each modification, and it goes without saying various variations can be made without departing from the gist of the present invention. Such various variations made without departing from the gist are also included in the technical scope of the present invention, and this is apparent to those skilled in the art from the description of the claims.

### Reference Signs List

1, E1, J1 conveyance system, 10, A10, E10 adsorption device, K50 vacuum generating device, 100, 200, 300, 400 cartridge, 110 cover, 111 top surface, 120 side surface, 121, 122, 123 flat surface, 130 curved surface, 131 to 133 boss part, 134, 135 claw part, 136, 137 exhaust port, 140 bottom part, 141 to 143 projecting part, 144, 145 recess part, 147, 148 through hole, 149 support part, 150 bottom surface, 151 to 155, 159 sidewall, 156 to 158 through hole, 160, 260, 360 vacuum pump, 161 side surface, 164 bottom surface, 167, 267, 467 suction hole, 169 emission hole, 180 terminal stand, 181 to 185 terminal, 189 substrate, 191 to 193, 196 to 198 bolt, 500, B00 main body, 510, 520, 530, 540 slot, 511 to 513 support wall, 514, 515 engaged part, 517, 527, 537, 547, 577, C77 connection port, 518 connector, 519 seal packing, 580 substrate, 590 upper surface, 610, 620, 630, 640, 650, 660, 670, C16, C26, C36, C46 ventilation path, 621 first space, 622 second space, 613, 623, 633, 643 check valve, 624, 634 spring, 615, 625, 635, 645 ventilation port, 656, 666, 676 coupling pipe, 617, 627, 637, 647, 657, 667, 677 socket, 690 bottom surface, 710, 720, 730, 740, 750, 760, 770, C10, C20, C30, C40, K70 adsorption pad, 751, 761 rubber plug, 800, F00 attachment, 810 display unit, 820 pressure sensor, 830 solenoid valve, 890 attachment part, 900, J00 robot arm, C00 adsorption frame, C50 frame, F40 connection part, G00 ground surface, J80 vacuum air pipe

## Claims

1. A vacuum generating device comprising:
a main body; and
an suction device including a vacuum pump, the suction device being removable from the main body, wherein
the main body and the suction device are engaged with each other by an engagement mechanism,
the suction device includes a terminal for supplying power to the vacuum pump, and a pipe for passing air sucked by operation of the vacuum pump,
the main body includes a connector to be connected with the terminal and a connection port to be connected with the pipe, and
the terminal of the suction device and the connector of the main body, and the pipe of the suction device and the connection port of the main body are connected to each other on a same surface as a surface for engagement of the engagement mechanism.

2. The vacuum generating device according to claim 1, wherein in the suction device, the terminal, the pipe, and a part of the engagement mechanism extend in a same direction.

3. The vacuum generating device according to claim 1, wherein
the suction device includes a part projecting in a direction intersecting a direction for mounting the suction device to the main body, and
the suction devices adjacent to each other are mounted to the main body such that the projecting parts respectively face different directions.

4. The vacuum generating device according to claim 1 further comprising a seal packing surrounding the terminal and the connector, and the pipe and the connection port.

5. The vacuum generating device according to any one of claims 1 to 4, comprising
an attachment for attaching the main body to an external device, wherein
a height of a top surface of the attachment is smaller than a height of a top surface of the suction device.

6. The vacuum generating device according to claim 5, wherein
a solenoid valve is formed outside the attachment, and
the attachment includes a part for connecting the attachment and the solenoid valve.

7. The vacuum generating device according to claim 6, comprising
a ventilation path communicating with the connection port; and
a check valve disposed at the ventilation path and switching between an open state and a closed state of the ventilation path, wherein
the check valve is
brought into a closed state in a state where the vacuum pump is stopped, and
brought into an open state during operation of the vacuum pump.

8. The vacuum generating device according to claim 7, wherein the check valve maintains a closed state even when the suction device is removed.

9. The vacuum generating device according to claim 8, wherein
a plurality of the suction devices are connected to the main body, and
the vacuum pump of each of the suction devices and the check valve connected to the suction device operate independently of operation of the vacuum pump of another suction device.

10. An adsorption device comprising:
the vacuum generating device according to claim 1; and
an adsorption pad removable from the main body.

11. The adsorption device according to claim 10, comprising
a socket communicating with the connection port via a ventilation path, wherein
the adsorption pad is connected to the socket.
